# EUROPEAN PATENT SPECIFICATION

(11) **EP 2 237 320 B1**
(45) Date of publication and mention of the grant of the patent: **19.03.2014**
(21) Application number: 08858001.4
(22) Date of filing: 05.12.2008
(51) Int. Cl.: H01L 29/78, H01L 21/28, H01L 21/336, H01L 21/8234, H01L 21/8238, H01L 27/088, H01L 27/092, H01L 29/423, H01L 29/49, H01L 29/51

(54) **METAL ELECTRODE AND SEMICONDUCTOR ELEMENT USING THE SAME**
METALLELEKTRODE UND HALBLEITERELEMENT DAMIT
ELECTRODE MÉTALLIQUE ET ÉLÉMENT SEMI-CONDUCTEUR ASSOCIÉ

(30) Priority: 07.12.2007 JP 2007317614
(43) Date of publication of application: 06.10.2010
(73) Proprietor: National Institute for Materials Science, Tsukuba-shi, Ibaraki 305-0047 (JP)
(72) Inventor: OHMORI, Kenji, Tokyo 162-0041 (JP); CHIKYO, Toyohiro, Tsukuba-shi Ibaraki 305-0047 (JP)
(74) Representative: Maillet, Alain
(86) International application number: PCT/JP2008/072164
(87) International publication number: WO 2009/072611

(56) References cited:
- WO-A1-2006/021906
- JP-A- 11 224 947
- JP-T- 2007 502 367
- JP-T- 2007 525 827
- LI ET AL: "Forming gas anneal induced flat-band voltage shift of metal-oxide-semiconductor stacks and its link with hydrogen incorporation in metal gates", MICROELECTRONIC ENGINEERING, ELSEVIER PUBLISHERS BV., AMSTERDAM, NL, vol. 84, no. 9-10, 30 May 2007 (2007-05-30), pages 2213-2216, XP022097272, ISSN: 0167-9317, DOI: 10.1016/J.MEE.2007.04.106
- JAE HOON LEE ET AL.: 'Tunable Work Function Dual Metal Gate Technology for Bulk and Non- Bulk CMOS' IEDM'2002 2002, pages 359 - 362, XP010626059
- K. OHMORI ET AL.: 'Wide Controllability of Flatband Voltage by Tuning Crystalline Microstructures in Metal Gate Electrodes' IEDM'2007 10 December 2007, pages 345 - 348, XP031389689
- KENJI OMORI ET AL.: 'Kinzoku Denkyoku/high-k Zetsuen Maku Capacitor no Flatband Den'atsu Tokusei ni Ataeru Shigoto Kansu Hencho Oyobi Netsu Shori no Eikyo' TECHNICAL REPORT OF IEICE, 2006, IEICE TECHNICAL REPORT SDM2006- 48 vol. 2006- 48, 2006, pages 37 - 41, XP008138396

## Description

### Technical Field

The present invention relates to a metal electrode and a semiconductor element using the same. In particular, the present invention relates to a metal electrode formed on a high-dielectric constant thin film.

### Background Art

A silicon oxide (SiO₂) film has been used as a gate insulation film in, for example, a CMOS circuit as a semiconductor element. This gate insulation film is advanced in film thinning. Recently, the film thickness of the gate insulation film has been reduced to less than 1 nm. However, when the film thickness of the gate insulation film is reduced to the size of some atoms, a leak current is increased. Unfortunately, the increase of the leak current reduces reliability. A polysilicon film has been used for a gate electrode. However, the film thinning of the gate electrode increases a ratio of the film thickness of a depletion layer in the polysilicon film occupied in the film thickness of the gate electrode. Unfortunately, the increase of the ratio causes the reduction of a current driving force which cannot be disregarded.

In order to solve such a problem, studies for replacing the silicon oxide film with a high dielectric constant (High-k) thin film to enhance the dielectric constant of the gate insulation film to increase the physical film thickness of the gate insulation film, or for replacing the polysilicon film with the metal electrode to suppress the depletion of the gate electrode have been actively performed.

In this case, a method for controlling the threshold voltage of a device using respective two metals having a different work function for an electrode of an N channel and an electrode of a P channel makes the CMOS circuit operate (for example, Patent Document 1). Patent Document 1 adjusts the film thickness of a layer made of a metallic material to be alloyed to adjust the gate electrode so as to have a suitable work function.

Patent Document 1: Japanese Patent Application Laid-Open No. 2006-199610. The patent US6271573 discloses a semiconductor device with gate structure and method of manufacturing the same.

### Summary of the Invention

### Problems to be Solved by the Invention

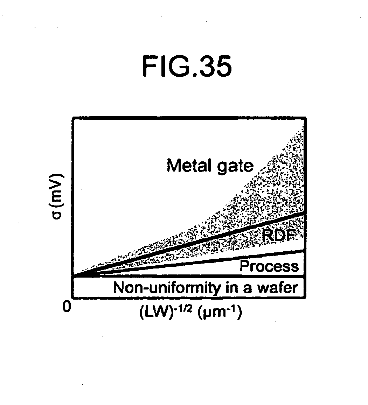

However, when a metal is deposited on the high-dielectric constant thin film even in the Patent Document 1, a gate electrode material and a gate insulation film material constituting the high-dielectric constant thin film react to unfortunately generate a phenomenon in which the effective work function of the gate electrode material is reduced (hereinafter, referred to as "a Fermi level pinning phenomenon"). Unfortunately, fluctuation of a threshold voltage (Vth) is larger. As shown in FIG. 35, generally, the fluctuation of the Vth is considered to be based on in-plane fluctuation (in FIG. 35, Non-uniformity in a wafer), fluctuation of processing size (in FIG. 35, Process), and fluctuation of impurity concentration(in FIG. 35, RDF). Since a more particular factor (in FIG. 35, Metal gate) is further added in the case of the metal electrode, the fluctuation may become very large. Thus, it is unfortunately difficult to obtain a desired threshold voltage in the metal electrode formed on the high-dielectric constant thin film.

In the light of the aforementioned problems, it is an object of the present invention to provide a metal electrode capable of controlling a threshold voltage and formed on a high-dielectric constant thin film, and a semiconductor element using the metal electrode.

### Means for Solving Problems

The aforementioned object is achieved in accordance with claim 1 of the present invention.

### Effects of the Invention

The metal electrode according to the present invention can control a work function and suppress fluctuation of a threshold voltage to control the threshold voltage.

### Brief Description of the Drawings

FIG. 1 is a sectional view of a CMOS circuit using a metal electrode according to the present invention.
FIG. 2 shows a manufacturing process by a gate last process of the CMOS circuit using the metal electrode according to the present invention, and shows the manufacturing process after dummy gate etching.
FIG. 3 shows the manufacturing process by the gate last process of the CMOS circuit using the metal electrode, FIG. 3(A) showing anneal, FIG. 3(B) showing ion implantation, FIG. 3(C) showing anneal.
FIG. 4 shows the manufacturing process by the gate last process of the CMOS circuit using the metal electrode, FIG. 4(A) showing the formation of side walls, FIG. 4(B) showing ion implantation to a drain and a source.
FIG. 5 shows the manufacturing process by the gate last process of the CMOS circuit using the metal electrode, FIG. 5(A) showing the formation of an interlayer insulation film, FIG. 5(B) showing the removal of a dummy gate.
FIG. 6 shows the manufacturing process by the gate last process of the CMOS circuit using the metal electrode, FIG. 6(A) showing the formation of a high-dielectric constant thin film, FIG. 6(B) showing the formation of a characteristic control film and a metal film.
FIG. 7 shows the manufacturing process by the gate first process of the CMOS circuit using the metal electrode according to the present invention, and shows the manufacturing process after gate etching.
FIG. 8 shows the manufacturing process by the gate first process of the CMOS circuit using the metal electrode, FIG. 8(A) showing anneal, FIG. 8(B) showing ion implantation, FIG. 8(C) showing anneal.
FIG. 9 shows the manufacturing process by the gate first process of the CMOS circuit using the metal electrode, FIG. 9(A) showing the formation of LDD side walls, FIG. 9(B) showing ion implantation to a drain and a source.
FIG. 10 shows the manufacturing process by the gate first process of the CMOS circuit using the metal electrode, and shows the formation of an interlayer insulation film.
FIG. 11 shows the results of examples, and shows the measurement results of the XRD intensities of characteristic control films annealed at 650°C.
FIG. 12 shows the results of Example 1, and shows two-dimensional XRD patterns.
FIG. 13 shows the results of Example 1, FIG. 13(A) showing a change in a Ru concentration based on a sputtering time, FIG. 13(B) being a photograph obtained by imaging the surface of the characteristic control film by an optical microscope.
FIG. 14 shows the results of Example 1, and shows the measurement results of XPS intensities before and after sputtering at a position of 5 mm of FIG. 13(A).
FIG. 15 shows the results of Example 1, FIG. 15(A) showing the results of C-V (capacity vs voltage) characteristics measured using the capacitor annealed at 600°C, FIG. 15(B) showing a flat band voltage to the Ru concentration.
FIG. 16 shows the results of Example 1, and shows the relationship between the Ru concentration and an electrical insulation film.
FIG. 17 shows the results of Example 1, and shows a sectional image by a transmission electron microscope (TEM) of a capacitor of HfSiON (4 nm)/SiO₂ (4 nm), FIG. 17(A) showing a case where a characteristic control film is made of Ru₇₀Mo₃₀, FIG. 17(B) showing a case where a characteristic control film is made of pure Ru.
FIG. 18 schematically shows the relationship of Mo, Ru and HfSiON, FIG. 18(A) showing a case where the characteristic control film is made of pure Mo, FIG. 18(B) showing a case where the characteristic control film is made of Ru₇₀Mo₃₀, FIG. 18(C) showing a case where the characteristic control film is made of pure Ru.
FIG. 19 shows the results of Example 1, FIG. 19(A) showing the measurement results of XRD intensities obtained by observing Mo thin films (Ru concentration: 0 mol%) into which C is added in amounts of 0, 3, and 10 mol%, FIG. 19(B) showing changes in sheet resistances of characteristic control films containing Ru and Mo when C is added into the characteristic control films.
FIG. 20 shows the results of Example 1, and shows the measurement results of XRD intensities obtained by observing characteristic control films containing Ru and Mo of as-depo, FIG. 20(A) showing the result when C is not added, FIG. 20(B) showing the result of the C concentration of about 1 mol%.
FIG. 21 shows plane images by a TEM showing the results of Example 2 and grain diameter size distributions, FIG. 21(A) showing a Ru₃₀Mo₇₀ film, FIG. 21(B) showing a Ru₅₀Mo₅₀ film.
FIG. 22 shows Id-Vg characteristics showing the results of Example 2, FIG. 22(A) using a metal electrode produced by a Ru₃₀Mo₇₀ film and having a gate length of 1 µm, FIG. 22(B) using a metal electrode produced by a Ru₅₀Mo₅₀ film and having a gate length of 1 µm, FIG. 22(C) using a metal electrode produced by a Ru₃₀Mo₇₀ film and having a gate length of 130 nm, FIG. 22(B) using a metal electrode produced by a Ru₅₀Mo₅₀ film and having a gate length of 130 nm.
FIG. 23 shows the results of Example 2, and shows gate width dependence of fluctuation of a Vth.
FIG. 24 shows Pelgrom Plot of standard deviation (σ) of a Vth (threshold) in a metal electrode showing the results of Example 2, FIG. 24(A) using a Ru₃₀Mo₇₀ film, FIG. 24(B) using a Ru₅₀Mo₅₀ film.
FIG. 25 shows a two-dimensional image by XRD showing the results of Example 3, FIG. 25(A) showing a Ru₅₀Mo₅₀ film at an upper side, FIG. 25(B) showing a film in which C is added to Ru₅₀Mo₅₀ at an upper side, FIGS. 25(A), 25(B) showing an effect obtained by adding C at respective lower sides.
FIG. 26 shows Pelgrom Plot of standard deviation (σ) of a Vth (threshold) in a metal electrode formed of a film in which C is added to Ru₅₀Mo₅₀ showing the results of Example 3.
FIG. 27 shows the results of Example 3, and shows the difference of values σ in a case of using a pair transistor formed of a Ru₅₀Mo₅₀ film to which C is added and a case of using an independent transistor.
FIG. 28 shows the results of Example 4, and shows the relationship between a plane direction and a work function in a metal having an fcc structure and a metal having a bcc structure.
FIG. 29 shows a plane image by TEM, a two-dimensional image by XRD, and a histogram which show the results of Example 4, FIG. 29(A) showing pure Mo having a bcc structure, FIG. 29(B) showing pure Ru having an fcc structure.
FIG. 30 shows the results of Example 4, and shows the relationship between the gate widths of pure Mo and pure Ru, and σ□
FIG. 31 shows the results of the comparative example, and shows a plane image by TEM of a TiN film and a grain diameter size distribution.
FIG. 32 shows the results of the comparative example, and shows XRD spectra of a TiN film having added C.
FIG. 33 shows Pelgrom Plot showing the results of the comparative example, FIG. 33(A) showing a case of using a TiN film, FIG. 33(B) showing a case of using a TiNC film.
FIG. 34 shows the results of the comparative example, and shows substrate concentration dependence of inclination in FIG. 33.
FIG. 35 schematically shows a factor of fluctuation of a Vth in the combination of a high-dielectric constant thin film and a metal electrode.

### Mode for Carrying Out the Invention

### 1. Overall Constitution

### (A) Control of Work Function

The present inventors examined a metal electrode used for a pair with a semiconductor so as to sandwich a high-dielectric constant thin film between the metal electrode and the semiconductor. As a result, the present inventors found that the metal electrode includes a metal film containing a first electrode material and a characteristic control film containing a second electrode material and formed between the high-dielectric constant thin film and the metal film, and thereby a work function can be stabilized. It is preferable that the first electrode material contains W and TiN or the like as primary components. Polysilicon may be used for the first electrode material.

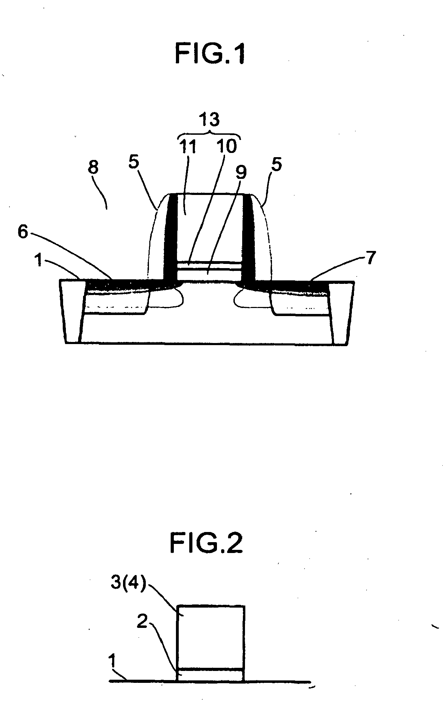

As shown in FIG. 1, a source 6 and a drain 7 are formed and separated a predetermined distance from each other on a silicon wafer 1 in a CMOS circuit as a semiconductor element according to the present embodiment. Impurities are implanted into the source 6 and the drain 7. A high-dielectric constant thin film 9 is provided on the silicon wafer 1 so as to cover the surface of the silicon wafer 1 between the source 6 and the drain 7. A metal electrode 13 is provided on the high-dielectric constant thin film 9. The metal electrode 13 includes a characteristic control film 10 containing the second electrode material, and a metal film 11 formed of the first electrode material. Furthermore, LDD side walls 5 are provided on the silicon wafer 1 so as to cover the both side surfaces of the high-dielectric constant thin film 9 thus formed and the both side surfaces of the metal electrode 13.

That is, the characteristic control film 10 according to the present invention contains, Ru (band gap: 4.92 eV) as a noble metal which is a metal having a large work function, and Mo (band gap: 4.09 eV) as the second electrode material which is a metal having a small work function. The characteristic control film 10 has a Mo high concentration layer on a surface (hereinafter, may be referred to as " a boundary face") brought into contact with the high-dielectric constant thin film 9. Herein, the concentration of Mo in the high concentration layer is preferably adjusted so that the concentration of Mo is higher than the average concentration of Mo in the whole characteristic control film 10. The high-dielectric constant thin film 9 is, for example, an HfO₂ film, an HfSiON film, and an HfAlO₂ film or the like. The characteristic control film 10 is an alloy containing Ru and Mo. Thereby, active oxygen contained in Ru is combined with Mo to form a thin electrical insulation film containing Mo-O on the boundary face. The action of the electrical insulation film formed on the boundary face is assumed to be able to stabilize the work function. Thereby, the metal electrode 13 according to the present invention achieves the work function difference of about 0.69 eV. Therefore, when the metal electrode 13 is used for the CMOS circuit, the low power consumption and high performance of the CMOS circuit are achieved.

In the metal electrode 13 according to the present invention, the concentration of Mo in the characteristic control film 10 is 3 mol% to 40 mol%. Thereby, since Mo can be stably segregated on the boundary face, the stability of the work function is further enhanced. The present inventors found a phenomenon that Mo is spontaneously segregated on the boundary face by adding Mo in an amount of 3 mol% to 40 mol% to Ru. Therefore, since the high concentration layer of Mo can be formed on the boundary face without having a particular process for forming the high concentration layer of Mo on the boundary face, the manufacturing process is simplified. The concentration of Mo in the characteristic control film 10 is more preferably 10 mol% to 40 mol%.

### (B) Suppression of Fluctuation of Threshold

The metal electrode 13 is used for a pair with the silicon wafer 1 as the semiconductor so as to sandwich an oxide film between the metal electrode 13 and the silicon wafer 1. The metal electrode 13 has the characteristic control film 10 to which C (carbon) is added. Thereby, the orientation and grain diameter of a crystal structure can be controlled. Therefore, when the metal electrode 13 is used for the CMOS circuit, fluctuation of a Vth is suppressed and the Vth is stably controlled.

The oxide film is the high-dielectric constant thin film 9. The metal electrode 13 includes the metal film 11 formed of the first electrode material, and the characteristic control film 10 containing Ru as the noble metal, and Mo as the second electrode material. The characteristic control film 10 is formed between the high-dielectric constant thin film 9 and the metal film 11. C is added to the characteristic control film 10. Thereby, the work function is stabilized, and the orientation and grain diameter of the crystal structure are controlled. Therefore, when the metal electrode 13 is used for the CMOS circuit, the low power consumption and high performance of the CMOS circuit are achieved.

An element reducing the crystal grain diameter of the characteristic control film 10 is selected from elements having a small atomic radius, for example, O, N, or Al or the like besides C. The crystal grain diameter of the characteristic control film 10 can be reduced by adding the element to the characteristic control film 10. The element can be added to the characteristic control film 10 by sputtering simultaneously with the formation of the characteristic control film 10. The additive amount of the element is preferably about 5 mol% to 15 mol%. As the crystal grain diameter of the characteristic control film 10 is reduced, for example, by adding C, the structure of the characteristic control film 10 is consequently changed to an amorphous structure.

It is preferable that the crystal structure of the characteristic control film 10 is an fcc structure. It was apparent from the experiment that even if the crystal grain diameters of the first electrode material and the second electrode material constituting the metal electrode 13 are identical, the fcc structure of the characteristic control film 10 as the crystal structure reduces fluctuation of a threshold as compared to a bcc structure thereof.

### (C) Modification

The present invention is not limited to the embodiment, and various modifications within the scope of the present invention are possible. For example, in the embodiment, the case where the metal electrode according to the present invention is applied to a gate electrode of the CMOS circuit as the semiconductor element is described. However, the present invention is not limited thereto. The metal electrode according to the present invention may be applied to a gate of a CMOS logic circuit, a control gate of a flash memory, and a gate of DRAM.

The metal electrode 13 constituted as described above can be used for various semiconductor elements, for example, a light emitting diode, a solar cell, a bipolar transistor, and a field effect transistor (FET) or the like. The crystal grain diameter of the first material constituting the metal film 11 may be reduced by adding C to the metal film 11.

### 2. Manufacturing Method

Next, a method for manufacturing the metal electrode in using the metal electrode for the CMOS circuit will be described. In manufacturing the CMOS circuit using the metal electrode according to the present invention, a method for manufacturing can be used, which includes a general transistor formation process and wiring formation process. The transistor formation process as a characteristic portion will be described below. In the transistor formation process, a portion related to the manufacture of the metal electrode according to the present invention is not different in nMOS and pMOS. Therefore, the portion will be described in the following description without distinguishing between the nMOS and the pMOS.

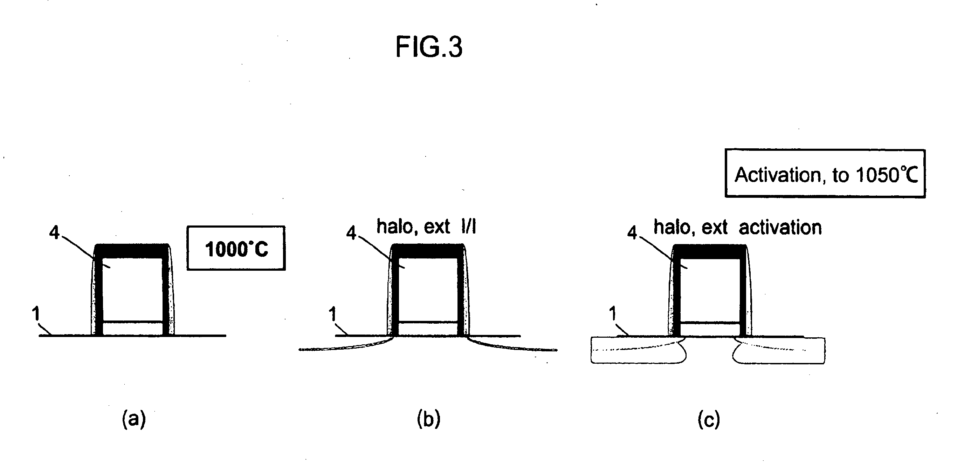

First, a gate last process finally forming the metal electrode will be described. An element isolation region (not shown) is formed on the silicon wafer 1, and a silicon oxide film 2 and a polysilicon film 3 are then formed. Then, a dummy gate 4 is formed in an etching process (FIG. 2). Ions are implanted with the dummy gate 4 as a mask, and annealing is performed (FIG. 3).

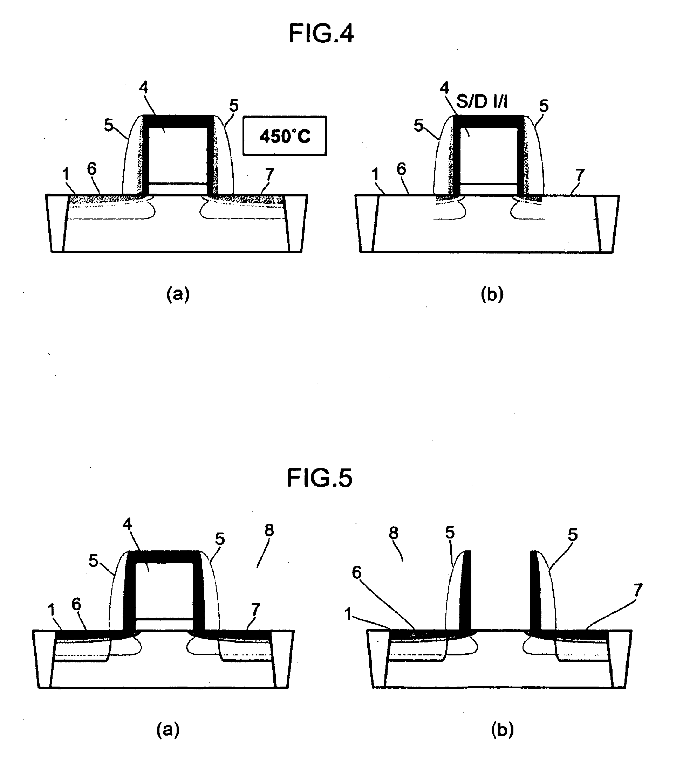

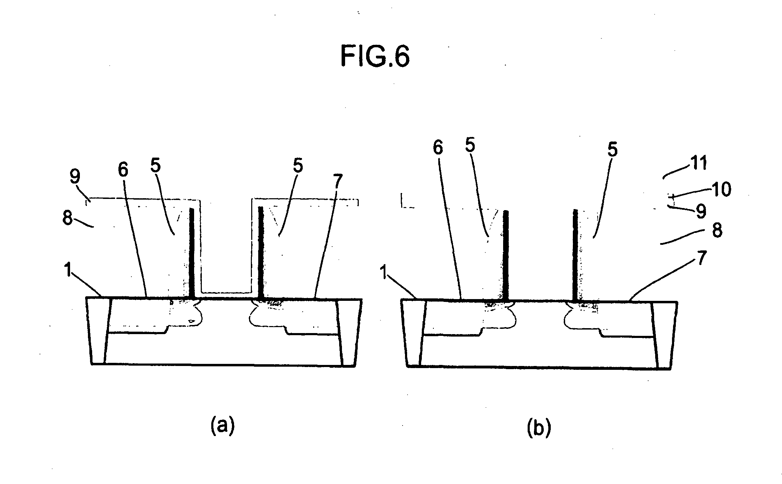

The LDD side walls 5 are formed, and ions are then implanted into portions which serve as the source 6 and the drain 7 (FIG. 4). An interlayer insulation film 8 is formed, and the surface thereof is planarized by chemical mechanical polish (CMP) (FIG. 5 (A)). Then, the dummy gate 4 is removed (FIG. 5 (B)). The dummy gate 4 and the silicon oxide film 2 are removed, and the high-dielectric constant thin film 9 is then formed. Then, after the high-dielectric constant thin film 9 is formed, C is added by sputtering while forming the characteristic control film 10. C is an element reducing the crystal grain diameter of a material constituting the characteristic control film 10. Then, the metal film 11 is sequentially formed to form the metal electrode 13 (FIG. 6). In the characteristic control film 10 formed on the high-dielectric constant thin film 9, Mo is segregated on the boundary face by performing annealing at about 450°C to form the high concentration layer (not shown) of Mo on the boundary face.

Thus, the source 6 and the drain 7 are previously formed with the dummy gate 4 as the mask. The dummy gate 4 is removed, and the high-dielectric constant thin film 9 is deposited. Then, the metal electrode 13 is produced. Thereby, since a low temperature process of 500°C or less can be achieved after forming the characteristic control film 10, the characteristic control film 10 to which C is added can be held in an amorphous state.

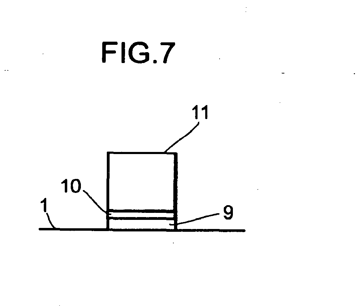

Next, a gate first process firstly forming the metal electrode will be described. The element isolation region (not shown) is formed on the silicon wafer 1. Then, the high-dielectric constant thin film 9 is formed. C is then added by sputtering while forming the characteristic control film 10. C is an element reducing the crystal grain diameter of a material constituting the characteristic control film 10. Then, the metal film 11 is sequentially formed to form the metal electrode 13 (FIG. 7). In the characteristic control film 10 formed on the high-dielectric constant thin film 9, Mo is segregated on the boundary face by performing annealing at about 450°C to form the high concentration layer of Mo (not shown) on the boundary face.

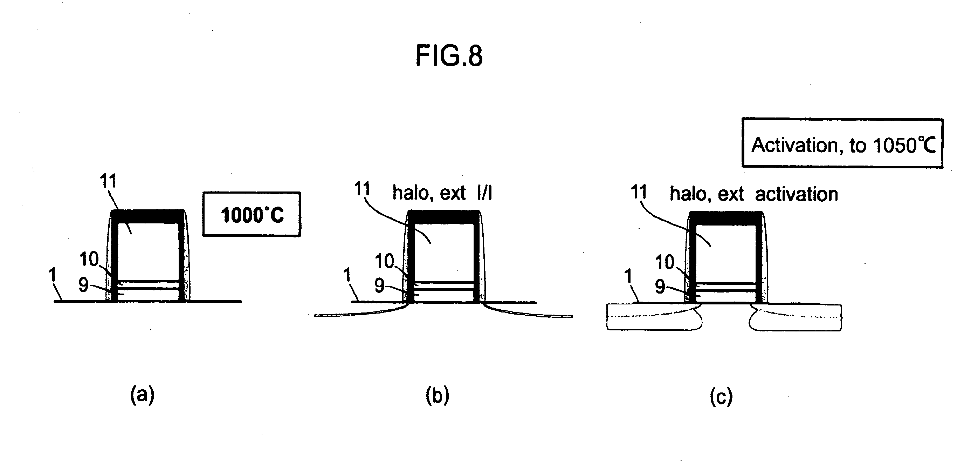

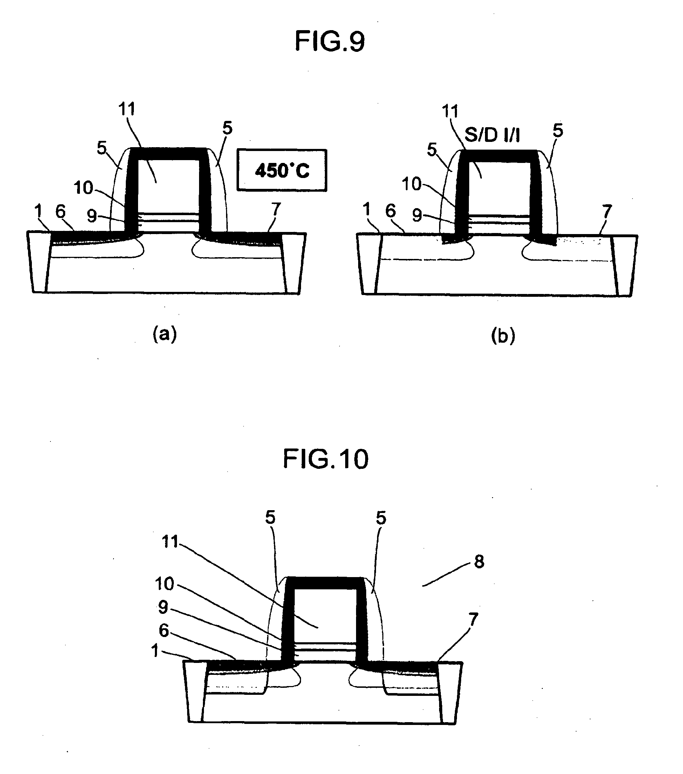

Then, ions are implanted, and annealing is performed (FIG. 8). The side walls are formed, and ions are then implanted into portions which serve as the source 6 and the drain 7 (FIG. 9). The interlayer insulation film 8 is formed, and the surface thereof is planarized by CMP (FIG. 10).

### 3. Examples

### (A) Example 1

Hereinafter, Examples will be described. In Example 1, a capacitor in which a characteristic control film was provided on a substrate was produced. The characteristics of a metal electrode according to the present invention were confirmed in the capacitor.

A substrate having an HfSiON/SiO₂/p-Si structure was used as a substrate on which the metal electrode according to the present invention was formed. In the substrate having the HfSiON/SiO₂/p-Si structure, HfSiON produced by an ALD (Atomic Layer Deposition)-CVD (Chemical Vapor Deposition) method was formed on an SiO₂/p-Si structure. A characteristic control film to which C was added to a Ru-Mo alloy was deposited on the substrate by 60 nm using a stencil mask (metal mask) by the ALD-CVD method to produce a capacitor having a diameter of 100 µm. A continuous characteristic control film was also produced without using the stencil mask. The characteristic control film was also subjected to physical analyses such as X ray photoelectron spectrometry (XPS) and X-ray diffraction analysis (XRD).

The characteristic control film was deposited at room temperature using an ion sputtering method and a magnetron sputtering method. As for the composition of the Ru-Mo alloy, a thin film having a composition continuously changed from Ru (100 mol%) to Mo (100 mol%) was produced on a substrate using a technique (a combinatorial technique) for synthesizing a large number of compound groups (library) at the same time according to the combination. C was added in amounts of 1, 3, and 10 mol% to the film to form the characteristic control films.

The capacitor was produced, and the capacitor was then annealed. C-V (capacity vs voltage) characteristics and I-V (current vs voltage) characteristics were measured. The annealing was performed in forming gas (FGA, in an atmosphere of 5% hydrogen and 95% nitrogen, 450°C) and in an oxygen environment (in an atmosphere of 1% oxygen and 99% nitrogen, 400°C to 800°C).

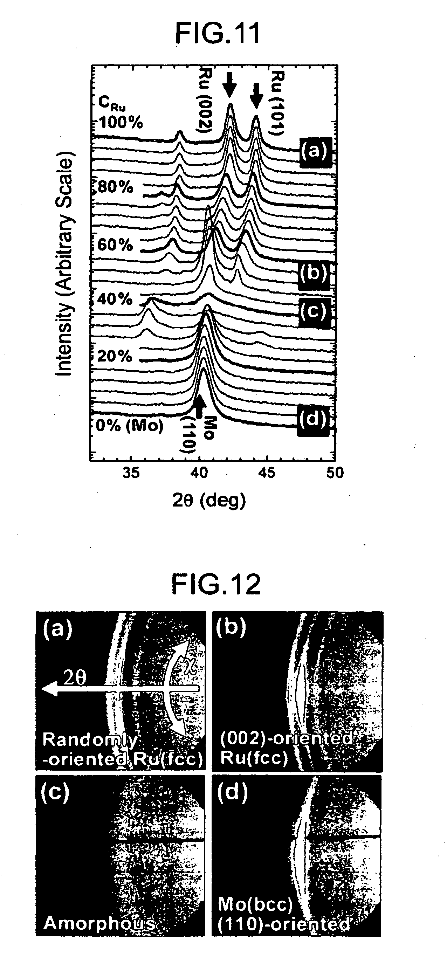

FIGS. 11 to 20 show results obtained by confirming the characteristics of the characteristic control films produced as described above. FIG. 11 shows the measurement results of the XRD intensities of the characteristic control films annealed at 650°C. It was confirmed that the composition passes an amorphous state temporarily when the composition of the film is changed from pure Mo (100 mol%) to pure Ru (100 mol%). FIG. 12 shows two-dimensional XRD patterns. It was confirmed that a pure Mo film has a body-centred cubic lattice structure (bcc), and a pure Ru film has a face-centered cubic lattice structure (fcc).

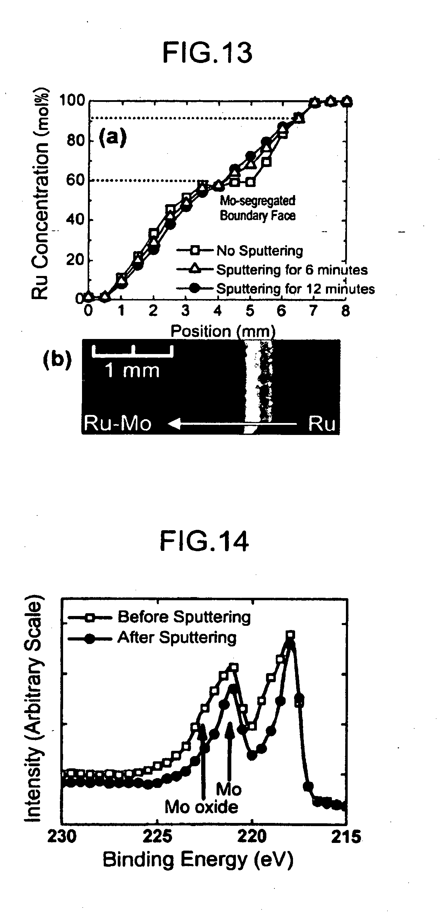

FIG. 13(A) shows a change in a Ru concentration based on a sputtering time for grinding the surface of the characteristic control film. From the results when sputtering is performed for 6 minutes and for 12 minutes in FIG. 13(A), it can be confirmed that the Ru concentration is substantially in proportion to a position. However, from the result of no sputtering, it was confirmed that the increasing amount of the Ru concentration is reduced at a position of 4 to 6.5 mm, and Mo is stably segregated on the surface at a position in which the Ru concentration is 60 to 90%. FIG. 13(B) is an optical microscope photograph of the surface of the characteristic control film. In FIG. 13(B), it was confirmed that Mo segregated on the surface appears brightly in a strip like shape.

FIG. 14 shows the measurement results of XPS intensities before and after sputtering at a position of 5 mm (Ru concentration: 73.3 mol%) of FIG. 13(A). A peak existing before sputtering and showing the existence of Mo-O of about 223 eV disappears after sputtering. A thin film including a bond of Mo-O is assumed to be formed on the boundary face between the Ru-Mo alloy and HfSiON.

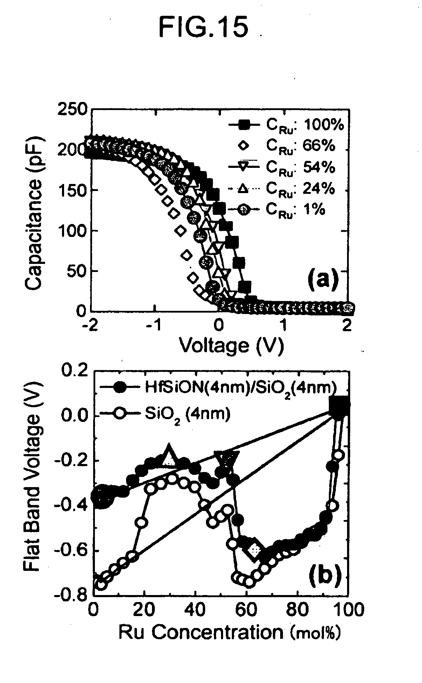

FIG. 15(A) shows the results of C-V (capacity vs voltage) characteristics measured using the capacitor annealed at 600°C. Characteristically, the Ru concentration of 66 mol% appears on the leftmost side. A flat band voltage (V_{fb}) of a capacitor of SiO₂ (4 nm) was compared with a capacitor of HfSiON (4 nm)/SiO₂ (4 nm) (FIG. 15(B)). The flat band voltage means a gate voltage capable of planarizing the energy band of a semiconductor by applying a voltage to a gate electrode. In the capacitor of SiO₂ (4 nm), it is found that the flat band voltage difference between Mo and Ru is 0.78 V. The difference between work functions at this time is 0.83 eV. However, when the Ru concentration is in the range of 60 mol% to 90 mol%, the flat band voltage is dramatically reduced. The flat band voltage when the Ru concentration is 60 mol% is -0.74 V, and is the same as that in the case of pure Mo. On the other hand, in the capacitor of HfSiON (4 nm)/SiO₂ (4 nm), the flat band voltage difference between Mo and Ru is reduced to 0.47 V by a fermi level pinning phenomenon on the boundary face between the high-dielectric constant thin film and the metal electrode. In the capacitor of HfSiON (4 nm)/SiO₂ (4 nm), it was confirmed that the flat band voltage is stable when the Ru concentration is in the range of 60 mol% to 90 mol%. Thereby, the flat band voltage when the Ru concentration is in the range of 60 mol% to 90 mol% is lower than the flat band in pure Mo. As a result, it was confirmed that the work function difference of 0.69 eV can be achieved in an HfSiON(4 nm)/SiO₂ (4 nm) structure.

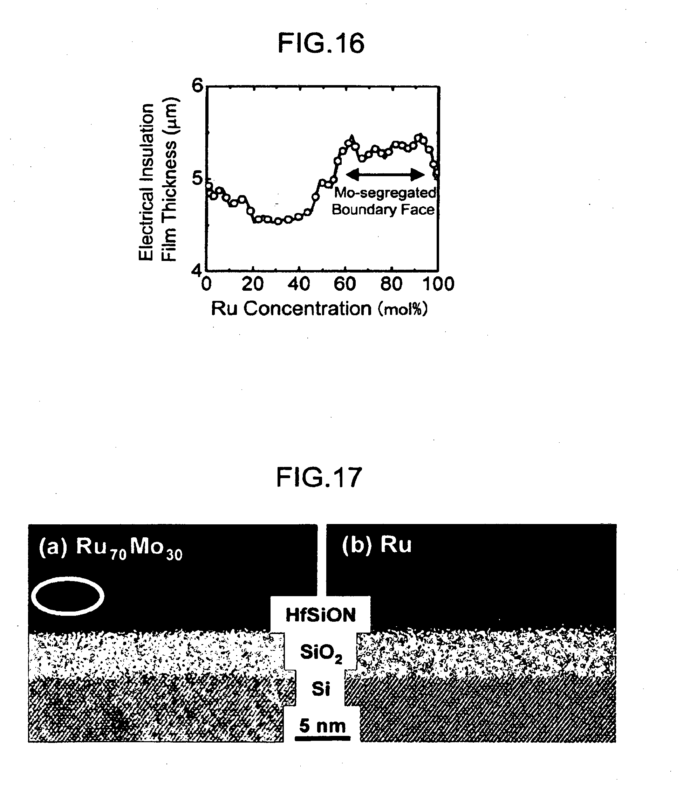

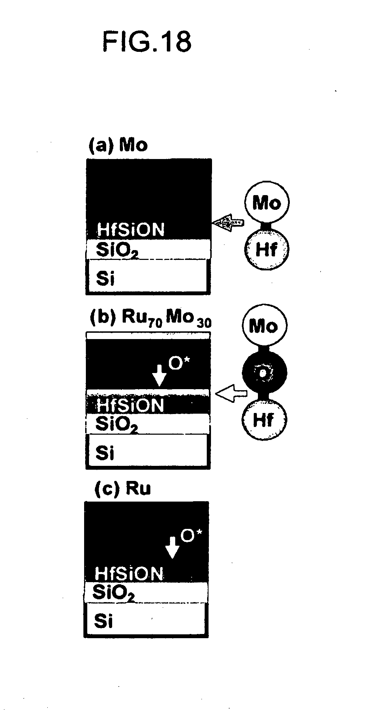

FIG. 16 shows the relationship between the Ru concentration and the electrical insulation film. When the Ru concentration is in the range of 60 mol% to 90 mol%, the electrical insulation film increases slightly. This means that an Mo oxide film is formed on the surface of a high-dielectric constant thin film. FIG. 17 shows a sectional image by a transmission electron microscope (TEM) of a capacitor of HfSiON (4 nm)/SiO₂ (4 nm). FIG. 17(A) shows a case where the characteristic control film is made of Ru₇₀Mo₃₀. FIG. 17(B) shows a case where the characteristic control film is made of pure Ru. A bright line (a portion enclosed with an ellipse of a white line in FIG. 17(A)) considered as the Mo oxide film is observed only in the characteristic control film made of Ru₇₀Mo₃₀. The thin Mo oxide film is considered to be formed of O atoms existing in a portion having a high concentration of Ru in the characteristic control film as shown in FIG. 18. The thin Mo oxide film formed on HfSiON is believed to stabilize the flat band voltage. In actuality, it could be confirmed that the electrical insulation film is not increased in an electrode made of pure Mo (FIG. 16).

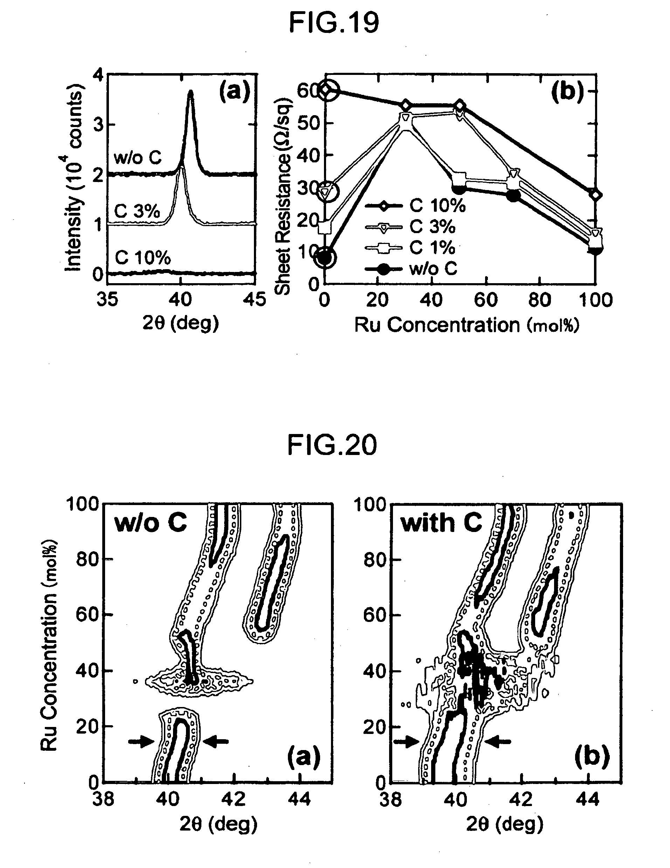

FIG. 19(A) shows the measurement results of XRD intensities obtained by observing Mo thin films (Ru concentration: 0 mol%) into which C is added in amounts of 0, 3, and 10 mol%. From FIG. 19(A), peaks showing crystals are decreased. It was confirmed that a crystal size is reduced by adding C and the Mo thin film is changed to an amorphous state. FIG. 19(B) shows changes in sheet resistances of characteristic control films containing Ru and Mo when C is added into the characteristic control films. As is apparent from FIG. 19(B), it is found that the addition of C and the change in the sheet resistance are also closely associated with a crystal structure. For example, when the Ru concentration is 0 mol% and the C concentration is increased to 10 mol% from 3 mol%, the sheet resistance is rapidly increased. This is because the crystal structure is changed to the amorphous state. When the Ru concentration is 30 mol%, the sheet resistance is the almost same value regardless of the existence or nonexistence of the addition of C. This is because the characteristic control film is already in the amorphous state before C is added when the Ru concentration is 30 mol%, and the state is not changed even if C is added.

FIG. 20 shows the measurement results of XRD intensities obtained by observing characteristic control films containing Ru and Mo immediately after forming the films. FIG. 20(A) shows the result when C is not added. FIG. 20(B) shows the result of the C concentration of about 1 mol%. In FIG. 20(B), the full width at half maximum (FWHM) of a peak shown by an arrow is increased in the total range of the Ru concentration. This shows that the crystal grain diameter is reduced.

### (B) Example 2

In Example 2, it is confirmed that fluctuation of the Vth can be suppressed when the crystal grain diameter of an alloy of Ru and Mo in a metal electrode made of the alloy is reduced. First, a sample was produced using the alloy of Ru and Mo.

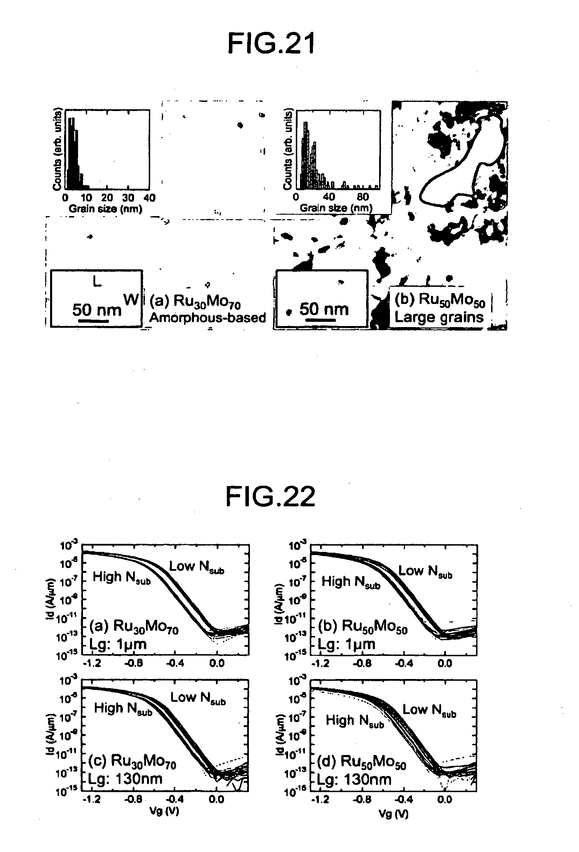

When an alloy is formed of Ru having an fcc structure as a crystal structure and Mo having a bcc structure, it was confirmed that a grain diameter size in a Ru₃₀Mo₇₀ film is reduced (FIG. 21(A)). A rectangle in FIG. 21(A) has a size of 100 nm × 150 nm, and corresponds to a transistor size formed in the trial production. In the Ru₃₀Mo₇₀ film, a crystal having an average grain diameter of 4 nm as a nanosize grain diameter could be confirmed in an amorphous base. On the other hand, in a Ru₅₀Mo₅₀ film (FIG. 21(B)), a crystal having a large grain diameter could be confirmed. In particular, in the upper right of FIG. 21(B), as surrounded by a line, a crystal having a large grain diameter of 100 nm or more could also be confirmed.

Metal electrodes having gate lengths (Lg) of 1 µm and 130 nm were respectively formed of the Ru₃₀Mo₇₀ film and the Ru₅₀Mo₅₀ film. The Id-Vg characteristics thereof were measured (FIG. 22). A transistor of HfSiON (2.5 nm)/SiO₂ (0.7 nm) was used as the high-dielectric constant thin film. A Vd (drain voltage) was -1.0 V, and substrate impurity concentrations were 6.0e17 cm⁻³ (High N_{sub} in FIG. 22), and 2.7e17 cm⁻³ (Low N_{sub} in FIG. 22). Thirty samples for each of the metal electrodes were measured. From this result, it was confirmed that the samples (FIG. 22(A), (C)) having a smaller crystal grain diameter have smaller fluctuation of the Id-Vg characteristics. In the samples (FIG. 22(B), (D)) having a larger crystal grain diameter, it was shown that fluctuation in the Id-Vg characteristics is larger in a particularly small device (FIG. 22(D)).

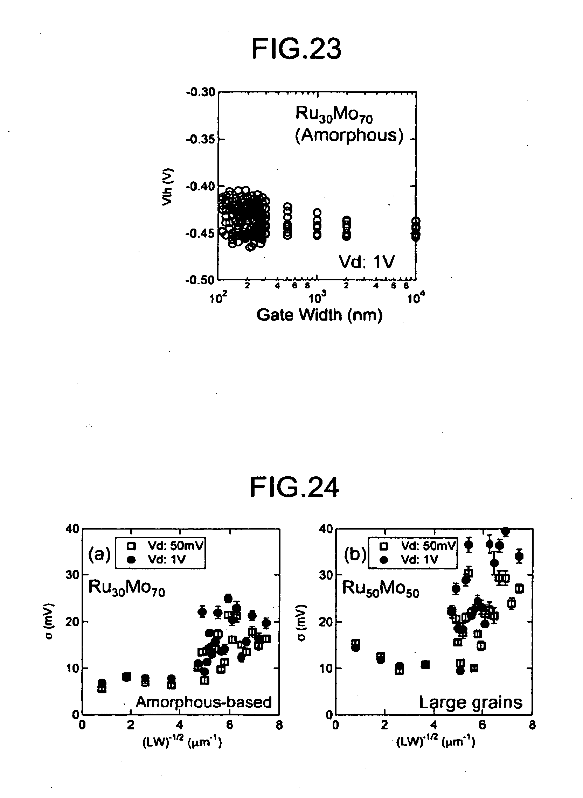

FIG. 23 shows the gate width dependence characteristics of Vth fluctuation. The sample is a metal electrode formed of the Ru₃₀Mo₇₀ film and having a gate length of 150 nm. It could be confirmed that the Vth fluctuation is increased as the gate width (W) is reduced to 10 nm from 10 µm.

FIG. 24 shows Pelgrom Plot of standard deviation (σ) of a Vth (threshold) in a metal electrode formed of the Ru₃₀Mo₇₀ film (FIG. 24(A)) and the Ru₅₀Mo₅₀ film (FIG. 24(B)). FIG. 24 shows that a value σ of the metal electrode having a larger crystal grain diameter (FIG. 24(B)) is larger.

As described above, it could be confirmed that the fluctuation of the Vth depends on the crystal grain diameter of the metal electrode, and the fluctuation of the Vth in the metal electrode having a smaller crystal grain diameter is smaller.

### (C) Example 3

Then, it is confirmed that the addition of C can change the structure of the metal electrode to an amorphous structure and can reduce the fluctuation of the Vth.

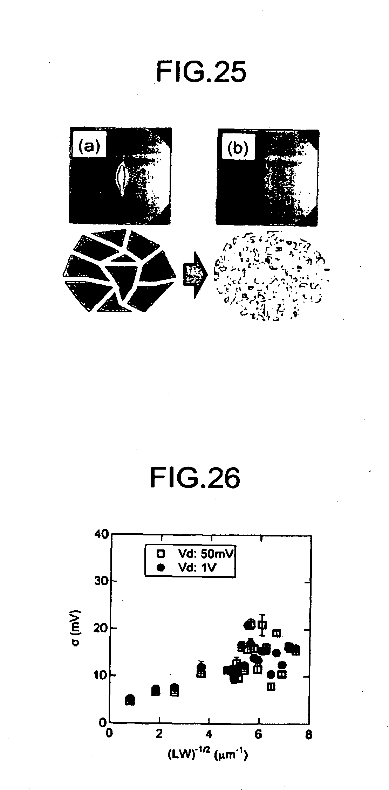

FIG. 25 shows X-ray diffraction analysis (XRD) results of a Ru₅₀Mo₅₀ film (FIG. 25(A)) and a film (FIG. 25(b)) in which C is added in an amount of 5 mol% to the Ru₅₀Mo₅₀ film. In FIG. 25(A), a sharp intensity distribution can be confirmed. This shows high crystallinity. On the other hand, in FIG. 25(B), an amorphous structure can be confirmed. Therefore, in the Ru₅₀Mo₅₀ film, it could be confirmed that the structure of the film is changed to the amorphous structure by adding C.

Furthermore, Pelgrom Plot of σ of a Vth in a Ru₅₀Mo₅₀ film to which C is added in an amount of 5 mol% is shown (FIG. 26). It could be confirmed that the value σ□of the amorphous structure formed by adding C is reduced as compared with FIG. 24(B) of the Ru₅₀Mo₅₀ film to which C is not added.

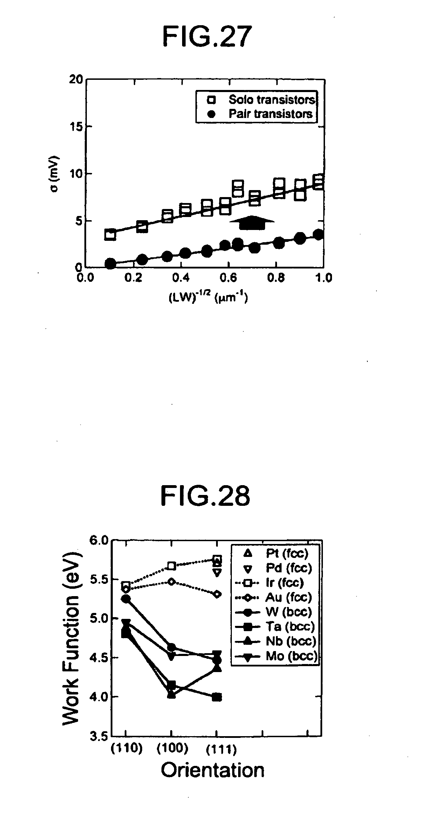

FIG. 27 shows the difference of values σ in a case of using a pair transistor formed of a Ru₅₀Mo₅₀ film to which C is added in an amount of 5 mol% and a case of using an independent transistor. The difference of the values σ in the case of using the independent transistor and the case of using the pair transistor is about 4 mV. In this experiment, it is found that the influence of in-plane fluctuation is small, and the experimental result (FIG. 26) shows a significant difference.

As described above, it could be confirmed that the metal electrode can be changed to the amorphous structure by adding C and the fluctuation of the Vth (threshold) can be reduced by using the metal electrode having the amorphous structure.

### (d) Example 4

Next, when the crystal structure of the characteristic control film is an fcc structure, it is confirmed that the fluctuation of the Vth is reduced.

First, FIG. 28 shows the relationship between a plane direction and a work function in metals (Pt, Pd, Ir, Au) having an fcc structure and metals (W, Ta, Nb, Mo) having a bcc structure (reference: H. B. Michaelson J. Appl. Phys. Vol. 48 (1977) 4729.). Three samples were used for each of the metals. From FIG. 28, it is confirmed that the work function is large in the bcc structure when the plane direction is a (100) plane, and the work function is large in the fcc structure when the plane direction is a (111) plane. It is shown that the plane direction dependence of the work function is high in the bcc structure.

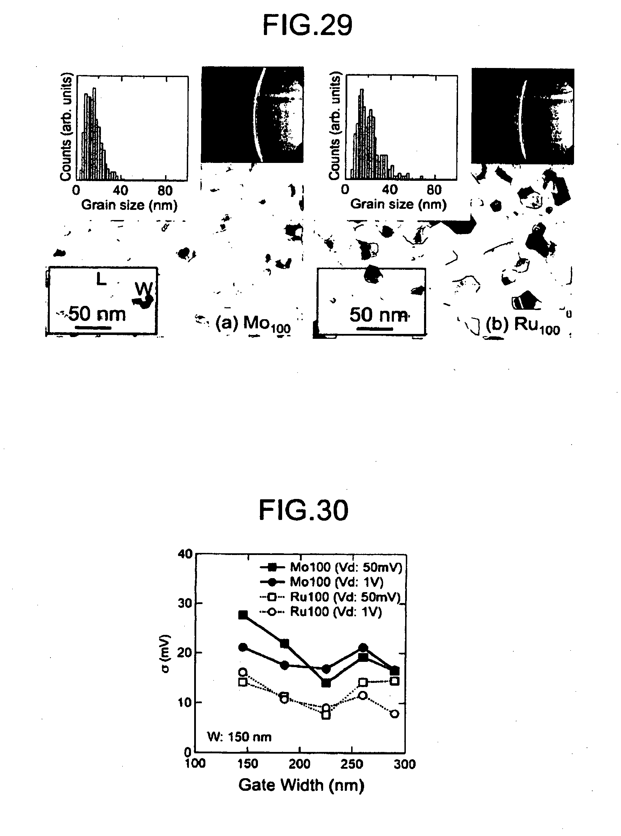

FIG. 29 shows the plane image by TEM, two-dimensional image by XRD, and histogram of pure Mo having the bcc structure and pure Ru having the fcc structure. A transistor of HfSiON (2.5 nm)/SiO₂ (0.7 nm) was used for the high-dielectric constant thin film. The film thickness of the pure Mo film or the pure Ru film as the characteristic control film formed on the high-dielectric constant thin film was set to 10 nm in any case. Furthermore, a W film was used as a metal film, and the film thickness thereof was set to 50 nm. FIG. 29 shows that a large number of small crystals gather in both pure Mo and pure Ru and size distributions are also similar to the histogram. In the two-dimensional image by XRD, a diffraction pattern drawing an arc shows that a crystal structure is a poly crystal structure.

FIG. 30 shows the relationship between a gate width and σ of a Vth in pure Mo having the bcc structure and pure Ru having the fcc structure. From FIG. 30, it was confirmed that the value σ of pure Mo having the bcc structure is 1.65 times larger than that of pure Ru having the fcc structure. Thereby, it was found that the fluctuation in the Vth is different based on the crystal structure even if the crystal grain diameter is almost the same, and the fluctuation of the fcc structure is smaller than that of the bcc structure. Therefore, it is considered that the fluctuation of the Vth can be further suppressed by using the material in which the crystal structure is the fcc structure.

### (e) Comparative example

Next, when TiN is used as a characteristic control film, it is confirmed that the addition of C can reduce a crystal grain diameter, and the reduction can suppress fluctuation of a Vth. A transistor of HfSiON (2.5 nm)/SiO₂ (0.7 nm) was used as a high-dielectric constant thin film. The film thickness of a TiN film as the characteristic control film formed on the high-dielectric constant thin film was set to 5 to 30 nm. Furthermore, a W film was used as a metal film, and the film thickness thereof was set to 50 nm.

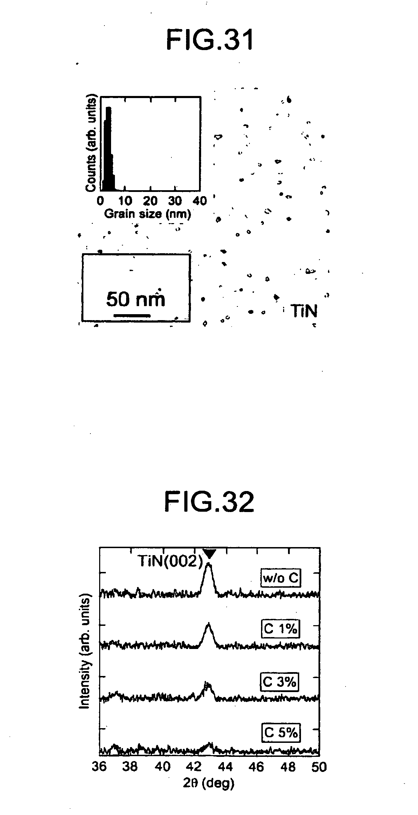

From a plane image by TEM (FIG. 31) of the TiN film, it could be confirmed that the TiN film has a small average grain diameter of 4.3 nm. However, from XRD spectrum when C is added to the TiN film shown in FIG. 32, it could be confirmed that the intensity of a XRD peak is reduced with the increase in the C concentration. This shows that the addition of C can further reduce the size and/or density of the crystal.

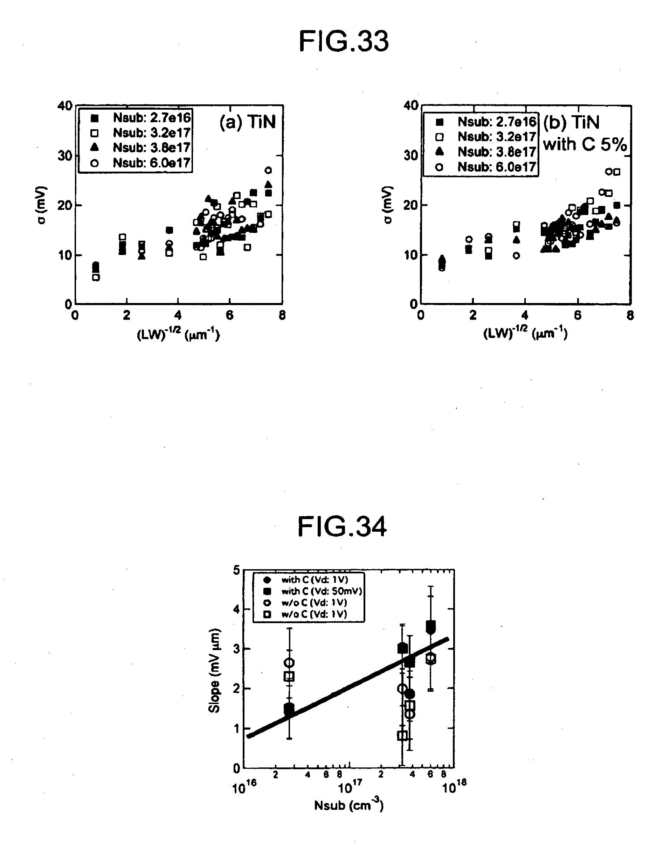

FIG. 33 shows Pelgrom Plot in the TiN film and the TiN film to which C is added in an amount of 5 mol%. Measurements were performed according to a substrate impurity concentration. From FIG. 33, the addition of C reduces the value σ of the Vth, and the linearity is observed. From FIG. 34, the substrate impurity concentration dependence of the value σ of the Vth could be confirmed by using the TiN film to which C was added.

As described above, it has been confirmed that the addition of C can reduce the crystal grain diameter even when TiN is used as the characteristic control film, and thereby the fluctuation of the Vth can be suppressed. Furthermore, the substrate impurity concentration dependence of the value σ of the Vth could be confirmed in the TiN film to which C was added.

## Claims

1. A metal electrode (13) formed on a high-dielectric constant thin film (9), the metal electrode comprising:
a metal film (11) containing a first electrode material; and
a characteristic control film (10) formed between the high-dielectric constant thin film (9) and the metal film (11),
**characterized in that** the characteristic control film (10) contains 3 to 40 mol% Mo and 60 to 90 mol% Ru, and **in that** the characteristic control film (10) comprises an Mo oxide film formed on a surface of the high-dielectric constant thin film (9).

2. The metal electrode (13) according to claim 1, **characterized in that** the characteristic control film (10) has a high concentration layer of Mo; the high concentration layer is formed on a surface brought into contact with the high-dielectric constant thin film (9); and a concentration of Mo in the high concentration layer is higher than an average concentration of Mo in the whole characteristic control film (10).

3. A semiconductor element **characterized in that** the metal electrode (13) according to any one of claims 1 to 2 is used for an N channel.

## Patentansprüche

1. Auf einem Dünnfilm (9) mit hoher Dielektrizitätskonstante gebildete Metallelektrode (13), welche Metallelektrode enthält:
einen Metallfilm (11), der ein erstes Elektrodenmaterial enthält; und
einen Kenngrößensteuerungsfilm (10), der zwischen dem Dünnfilm (9) mit hoher Dielektrizitätskonstante und dem Metallfilm (11) gebildet ist,
**dadurch gekennzeichnet, dass** der Kenngrößensteuerungsfilm (10) 3 bis 40 Mol-% Mo und 60 bis 90 Mol-% Ru enthält, und dadurch, dass der Kenngrößensteuerungsfilm (10) einen auf einer Oberfläche des Dünnfilms (9) mit hoher Dielektrizitätskonstante gebildeten Mo-Oxidfilm aufweist.

2. Metallelektrode (13) nach Anspruch 1, **dadurch gekennzeichnet, dass** der Kenngrößensteuerungsfilm (10) eine Mo-Schicht mit hoher Konzentration hat; wobei die Schicht mit hoher Konzentration auf einer Oberfläche gebildet ist, die mit dem Dünnfilm (9) mit hoher Dielektrizitätskonstante in Kontakt gebracht ist; und eine Konzentration von Mo in der Schicht mit hoher Konzentration höher als eine durchschnittliche Konzentration von Mo in dem gesamten Kenngrößensteuerungsfilm (10) ist.

3. Halbleiterelement, **dadurch gekennzeichnet, dass** die Metallelektrode (13) nach einem der Ansprüche 1 bis 2 für einen N-Kanal verwendet wird.

## Revendications

1. Une électrode métallique (13) formée sur un film mince à haute constante diélectrique (9), l'électrode métallique comprenant:
un film métallique (11) contenant un premier matériau d'électrode, et
un film de contrôle de caractéristique (10) formé entre le film mince à haute constante diélectrique (9) et le film métallique (11),
**caractérisée en ce que** le film de contrôle de caractéristique (10) contient 3 à 40 moles% de Mo et 60 à 90% de moles de Ru, et **en ce que** le film de contrôle de caractéristique (10) comprend un film d'oxyde Mo formée sur une surface du film mince à haute constante diélectrique (9).

2. L'électrode métallique (13) selon la revendication 1, **caractérisée en ce que** le film de contrôle de caractéristique (10) a une couche de forte concentration de Mo, la couche de forte concentration est formée sur une surface mise en contact avec le film mince à haute constante diélectrique (9), et une concentration de Mo dans la couche de concentration élevée est supérieure à une concentration moyenne de Mo dans l'ensemble du film de contrôle de caractéristique (10).

3. Un élément semi-conducteur **caractérisé en ce que** l'électrode métallique (13) selon l'une quelconque des revendications 1 à 2 est utilisé pour un canal N
